(19) Europäisches Patentamt / European Patent Office / Office européen des brevets

(11) **EP 3 392 550 A1**

(12) **EUROPEAN PATENT APPLICATION**
published in accordance with Art. 153(4) EPC

(43) Date of publication:
**24.10.2018 Bulletin 2018/43**

(21) Application number: **16875181.6**

(22) Date of filing: **13.09.2016**

(51) Int Cl.:
*F21S 2/00* (2016.01)     *F21V 8/00* (2006.01)
*G02B 5/10* (2006.01)     *G02B 6/00* (2006.01)
*G02B 17/08* (2006.01)    *H01L 33/00* (2010.01)
*H01L 33/58* (2010.01)    *H01L 33/60* (2010.01)
*F21Y 115/10* (2016.01)

(86) International application number:
**PCT/JP2016/076995**

(87) International publication number:
**WO 2017/104195 (22.06.2017 Gazette 2017/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **18.12.2015 JP 2015247922**

(71) Applicant: **Kabushiki Kaisha Toshiba
Minato-ku
Tokyo 105-8001 (JP)**

(72) Inventors:
• **HAYASHIHARA Hiromichi
  Tokyo 105-8001 (JP)**
• **OHNO Hiroshi
  Tokyo 105-8001 (JP)**
• **SUZUKI Tomoyuki
  Tokyo 105-8001 (JP)**
• **TAKAMATSU Tomonao
  Tokyo 105-8001 (JP)**
• **MORINO Takeshi
  Tokyo 105-8001 (JP)**

(74) Representative: **Hoffmann Eitle
Patent- und Rechtsanwälte PartmbB
Arabellastraße 30
81925 München (DE)**

(54) **OPTICAL ELEMENT AND LED LIGHTING DEVICE**

(57)     An optical element according to an embodiment includes: an incidence surface facing a light source; a side surface intersecting with the incidence surface; and a recessed surface facing the incidence surface and intersecting with the side surface, the recessed surface having a shape protruding toward the incidence surface, wherein the recessed surface includes: a first surface having a shape of a curved surface through which a central axis connecting a central portion of the incidence surface and a central portion of the recessed surface extends; and a second surface joined to the first surface and to the side surface, the first surface transmits light, a light reflecting member is provided on the second surface, and a cross-section of the optical element perpendicular to the central axis has a uniform external shape.

FIG.10

**Description**

FIELD

Embodiments described herein relate generally to an optical element and an LED lighting device.

BACKGROUND

A light-emitting diode (LED) lighting device for general lighting is sometimes expected to have a shape like an incandescent bulb and emit light like an incandescent bulb. That is, retrofitting is sometimes desired. Particularly, there is often a demand for wide light distribution from a point light source inside a globe as in a case with a clear incandescent bulb, such as an incandescent bulb having a globe formed with clear glass. For example, there is a demand for lighting of approximately 270 degrees in 1/2 light distribution angle. However, if an LED is used as a light source, the light distribution angle becomes narrower, and the 1/2 light distribution angle decreases to approximately 120 degrees. In view of this, the light distribution angle may be widened with an optical element, such as a wide distribution lens.
Concerning such wide distribution lenses, an example using a rod-like optical element that has white coating applied therein is known (JP2014-063614A). However, light emitted from the white coating surface has luminance lowered due to the scattering characteristics of the white coating surface, and shines in a different manner from an incandescent bulb. For this reason, there is a demand for a method of spreading light over a wide range while maintaining the high luminance of an LED.

Technical Problem

This embodiment provides an optical element and an LED lighting device that are capable of distributing light in all directions without a change in the high luminance of the LED.

SUMMARY OF THE INVENTION

An optical element according to an embodiment includes: an incidence surface facing a light source; a side surface intersecting with the incidence surface; and a recessed surface facing the incidence surface and intersecting with the side surface, the recessed surface having a shape protruding toward the incidence surface, wherein the recessed surface includes: a first surface having a shape of a curved surface through which a central axis connecting a central portion of the incidence surface and a central portion of the recessed surface extends; and a second surface joined to the first surface and to the side surface, the first surface transmits light, a light reflecting member is provided on the second surface, and a cross-section of the optical element perpendicular to the central axis has a uniform external shape.

BRIEF DESCRIPTION OF THE DRAWINGS

FIG. 1 is a diagram showing the cross-sectional shape of an optical element according to a first embodiment.
FIG. 2 is a diagram showing a light distribution of the optical element according to the first embodiment.
FIG. 3 is a cross-sectional view of an LED lighting device using the optical element of the first embodiment.
FIG. 4 is a diagram for explaining effects of the optical element of the first embodiment.
FIG. 5 is a diagram for explaining effects of the optical element of the first embodiment.
FIG. 6 is a diagram for explaining effects of the optical element of the first embodiment.
FIGS. 7(a) and 7(b) are diagrams for explaining effects of the optical element of the first embodiment.
FIG. 8 is a graph showing results of a parameter survey of the optical element of the first embodiment.
FIG. 9 is a graph showing results of a parameter survey of the optical element of the first embodiment.
FIGS. 10(a) and 10(b) are diagrams showing the cross-sectional shapes of optical elements according to a second embodiment and a modification thereof.
FIG. 11 is a diagram showing a light distribution of the optical element according to the modification of the second embodiment.
FIG. 12 is a cross-sectional view of an LED lighting device using the optical element of the second embodiment.
FIGS. 13(a), 13(b), and 13(c) are cross-sectional views of optical elements according to a third embodiment, a first modification, and a second modification.
FIG. 14 is a diagram showing a light distribution of an LED lighting device using the optical element of the third embodiment.

FIGS. 15(a) through 15(f) are cross-sectional views and plan views showing the cross-sectional shapes of optical elements according to a fourth embodiment and first through fifth modifications.

FIG. 16 is a cross-sectional view of an optical element according to a third modification of the third embodiment.

## DETAILED DESCRIPTION

The following is a description of embodiments, with reference to the accompanying drawings.

(First Embodiment)

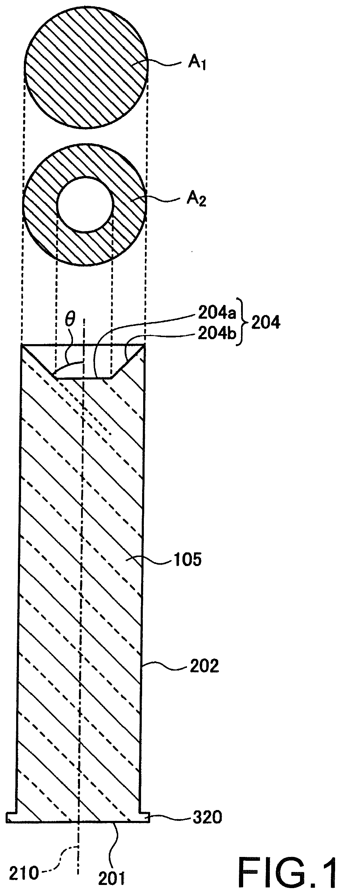

FIG. 1 shows an optical element according to a first embodiment. This optical element 105 is made of a transparent material having a refractive index n. Specifically, the optical element 105 is made of a resin such as polymethylmethacrylate (PMMA) or polycarbonate (PC), or glass. The optical element 105 has an incidence surface 201 that faces an LED (not shown) and receives light from the LED, a side surface 202 that intersects with the incidence surface 201 in the normal direction of the incidence surface 201, and a recessed surface 204 that faces the incidence surface 201 and intersects with the side surface 202. In this embodiment, the recessed surface 204 has a shape that protrudes toward the incidence surface 201. In the optical element 105, the incidence surface 201, the side surface 202, and the recessed surface 204 are smooth surfaces.

It should be noted that the optical element 105 may have a protruding portion (a flange) 320 that is formed on the side surface 202 and extends from the incidence surface 201. The protruding portion 320 is to be used for readily attaching the optical element 105 to an LED lighting device, and may not be prepared. In that case, the optical element 105 is attached to an LED lighting device with an adhesive or by fitting. The protruding portion 320 may have any shape as long as it serves to secure the optical element 105. Further, the protruding portion 320 is not necessarily located near the incidence surface 201 and may be located in any position on the side surface 202.

The optical element 105 has a rod-like shape except for the protruding portion 320. That is, the external shapes of cross-sections of the optical element 105 are the same, and the cross-sections from the incidence surface 201 to the lowermost surface of the recessed surface 204 have substantially the same area. Because of this, the optical element 105 is also called a light guiding rod. As will be described later, the cross-sectional shape of the optical element 105 may not be a round shape but may be a polygonal shape, an elliptical shape, or a petal shape. Because the optical element 105 is manufactured with a mold, the optical element 105 has a portion in which the cross-sectional area slightly decreases due to a draft angle. However, as this decrease in the cross-sectional area is small, the cross-sectional area is regarded as uniform.

The central axis 210 of the optical element 105 is a direction parallel to the side surface 202, and the direction from the incidence surface 201 toward the recessed surface 204 is the positive direction. The shape of the optical element 105 is rotationally symmetric, for example. Here, being rotationally symmetric means that, when the object is rotated about the rotation axis, the shape matches the original shape at a rotation angle smaller than 360 degrees. However, the shape is not necessarily a rotationally symmetric shape. In the case of a rotationally symmetric shape, the central axis 210 of the optical element 105 coincides with the axis of rotational symmetry. The central axis 210 also coincides with an axis perpendicular to the light-emitting surface of the LED, or with the optical axis.

The recessed surface 204 further has a first surface 204a intersecting with the central axis 210, and a second surface 204b that is joined to the first surface 204a and is joined to the side surface 202. The first surface 204a and the second surface 204b are formed with flat surfaces. The first surface 204a is a transmissive surface, and the second surface 204b is a reflective surface with a reflecting member. The reflecting member is formed through evaporation of a metal such as aluminum, plating, or gloss coating, for example.

Where $A_1$ represents a projected area obtained by projecting the recessed surface 204, which is the surface formed with the first surface 204a and the second surface 204b, onto a plane perpendicular to the central axis 210, and $A_2$ represents a second projected area obtained by projecting the second surface 204b onto a plane perpendicular to the central axis 210, the projected area ratio a of the second surface 204b satisfies the condition shown in the following expression (1).

$$a = \frac{A_2}{A_1} \geq 0.5 \qquad (1)$$

Further, where X represents the 1/2 light distribution angle, and n represents the refractive index of the optical element 105, the angle $\theta$ of the second surface 204b with respect to the central axis 210 satisfies the condition shown below in the expression (2), and is preferably smaller than 50 degrees, or more preferably, smaller than 45 degrees.

$$\theta \geq \frac{\sin^{-1}\left(\frac{1}{n}\right) + \sin^{-1}\left\{\frac{1}{n} \times \left[-\cos\left(\frac{X}{2}\right)\right]\right\}}{2} \qquad (2)$$

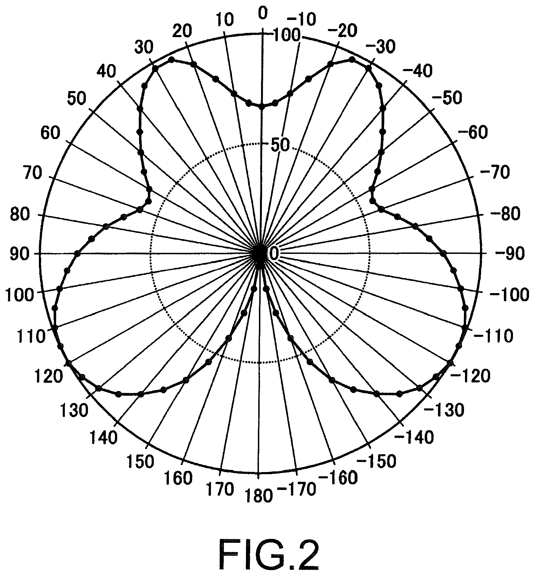

FIG. 2 shows the light distribution by the optical element 105. As can be seen from FIG. 2, it is possible to achieve a wide light distribution with a 1/2 light distribution angle of 310 degrees.

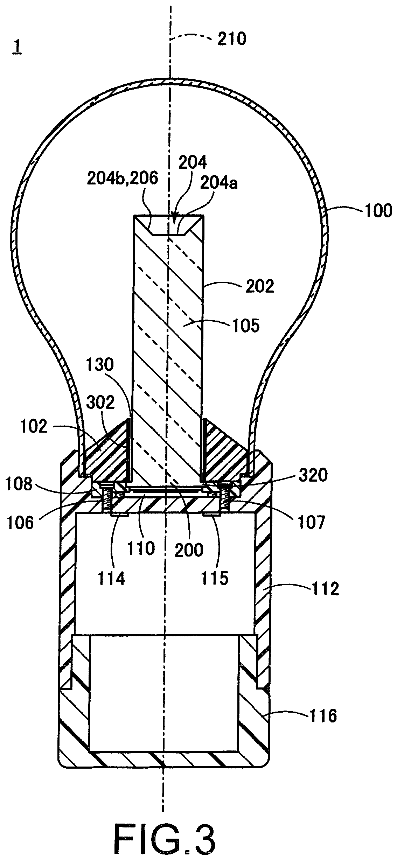

FIG. 3 shows a cross-section of an LED bulb using the optical element 105 of this embodiment. An LED lighting device 1 of the first embodiment includes a globe 100, a cover (a covering portion) 102, the optical element 105, spacer fixing screws 106 and 107, a spacer 108, an LED 110, a housing 112, cover fixing screws 114 and 115, and a cap 116. That is, the LED lighting device 1 of the first embodiment is an LED bulb.

The LED 110 is located between a recess of the housing 112 serving as the base and the spacer 108.

The spacer 108 is attached to the recess of the housing 112 by the spacer fixing screws 106 and 107, so that a portion of the LED 110 is pressed against and fixed to the surface of the recess of the housing 112 by the spacer 108. The spacer 108 is designed to have a recessed portion in which the protruding portion 320 of the optical element 105 is accommodated. The opposite side of the housing 112 from the side having the LED 110 fixed thereto is a cylindrical portion, and this cylindrical portion is covered with the cap 116. A through hole into which the optical element 105 is to be inserted is formed in the central portion of the spacer 108. The housing 112 has a heat releasing function.

The cover 102 is provided at a side portion of the optical element 105 on the side closer to the incidence surface 201, and this cover 102 is fixed to the housing 112 by the cover fixing screws 114 and 115. A light absorbing portion 302 is formed on the surface of the cover 102 facing the optical element 105. An air layer 130 exists between the light absorbing portion 302 and the side surface 202 of the optical element 105.

The optical element 105 and the cover 102 are covered with the globe 100, and are contained in the globe 100. The globe 100 is bonded and fixed to the housing 112 with an adhesive, for example.

In the LED lighting device 1 of the first embodiment, the housing (socket) 112 has a heat releasing function, and the LED 110, the optical element 105, and the globe 100 are integrally secured to the housing 112 by the spacer 108, the cover 102, the screws 114 and 115, and the like. Thus, an LED lighting device integrally formed with a housing that has a heat releasing function is obtained.

(Principles of Lighting)

The principles of lighting in the LED lighting device 1 of the first embodiment are now described. The LED 110 disposed on the bottom surface side of the optical element 105 is supplied with power by a power supply and a wire (not shown), and emits light.

The light from the LED 110 propagates inside the optical element 105, passes through the first surface 204a at the top edge, is reflected by the second surface 204b, and widely exits in all directions. Thus, it is possible to obtain an efficient LED lighting device that widely distributes light with the high luminance of the LED 110.

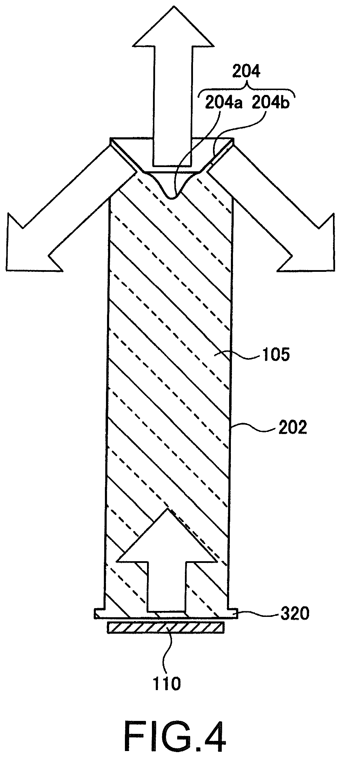

Referring now to FIGS. 4 through 7, the effects of the optical element 105 of the first embodiment are described. FIG. 4 is a diagram showing the basic principles of a wide light distribution by the optical element 105. Light that has entered the optical element 105 from the light source (LED) 110 propagates in the optical element 105, and reaches the recessed surface 204. The transmissive surface formed with the first surface 204a and the reflective surface formed with the second surface 204b are formed on the recessed surface 204. The light that has reached the first surface (transmissive surface) 204a refractively passes through the first surface (transmissive surface) 204a, and spreads in the direction of the central axis 210. The light that has reached the second surface (reflective surface) 204b is reflected by the second surface (reflective surface) 204b, refractively passes through the side surface 202, and spreads in different directions from the direction of the central axis 210. Thus, it is possible to distribute light in a wide region without a change in the luminance of the LED 110.

If the projected area of the first surface (transmissive surface) 204a is the same as the projected area of the second surface (reflective surface) 204b in this case, the proportion of the transmitted light and the proportion of the reflected light are the same. However, the proportion of the transmitted light is larger in the light distribution, and therefore, the 1/2 light distribution angle becomes narrower. In view of this, the proportion of the second surface (reflective surface) 204b is made larger than that of the first surface (transmissive surface) 204a, to achieve a wider light distribution. Therefore, the ratio a (= $A_2/A_1$) of the projected area $A_2$ of the second surface (reflective surface) 204b to the projected area $A_1$ of the recessed surface 204 shown in FIG. 1 is 0.5 or higher. In FIG. 4, unlike the first surface 204a shown in FIG. 1, the first surface 204a is not flat but is recessed toward the LED 110. As shown in FIG. 4, the first surface 204a may be recessed toward the LED 110. The optical element 105 shown in FIG. 4 will be described later as an optical element of a second embodiment. In a case where the first surface 204a is a flat surface, a light beam that enters the first surface 204a from the side surface 202 of the optical element 105 at a large incident angle has a larger incident angle than the critical angle $\theta_c$ on the first surface 204a, and therefore, is totally reflected. Further, such a light beam is totally reflected again by the side surface 202, and propagates in the optical element 105, to return to the LED 110. As a result, efficiency becomes lower. In view of this, the first surface 204a may be designed as a curved surface, to effectively increase efficiency.

As for the proportions in the light distribution, only transmitted light is emitted in a region of $\pm 45$ degrees with respect to the central axis 210, and only reflected light is emitted in the other regions, for example. In this case, the proportion of the transmitted light is about 1/3, because the partial solid angle of $\pm 45$ degrees is 1.41n, and the total solid angle is 4n. In other words, to keep balance in the light distribution, the amount of light emitted from the second surface (reflective surface) 204b needs to be almost twice as large as the amount of the transmitted light. Accordingly, where the ratio between the transmitted light and the reflected light is about 1 : 2, the proportion of the light emitted from the first surface (transmissive surface) 204a and the proportion of the light emitted from the second surface (reflective surface) 204b are almost the same in the light distribution, and thus, the 1/2 light distribution angle can be widened. At this point, the projected area ratio a of the second surface (reflective surface) 204b is about 0.75. In practice, transmitted light and reflected light are not necessarily separated at $\pm 45$ degrees, and therefore, the best projected area ratio a is around 0.75.

As described above, to achieve a wide light distribution, the projected area ratio a of the second surface (reflective surface) 204b preferably satisfies the condition shown in the expression (1), and is preferably around 0.75. The projected area ratio a is preferably not lower than 0.6 and not higher than 0.9, or more preferably, not lower than 0.7 and not higher than 0.85.

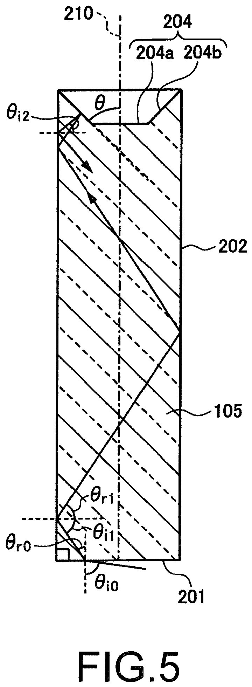

In a case where the angle $\theta$ of the second surface (reflective surface) 204b with respect to the central axis 210 is large, when light reflected by the second surface (reflective surface) 204b enters the side surface 202 of the optical element 105, the incident angle $\theta_i$ of the reflected light is larger than the critical angle. Because of this, light that returns while being totally reflected in the optical element 105 is generated. As this light returns to the light source (LED) 110 and is then absorbed or scattered by the phosphor, the efficiency of the light bulb becomes poorer. This aspect is now described with reference to FIG. 5.

Of light that has entered the optical element 105 from the incidence surface 201, the light totally reflected by the side surface 202 of the optical element 105 satisfies the condition shown in the expression (3), where n represents the refractive index of the optical element 105, and $\theta_i$ represents the incident angle to the side surface 202 (the reference being the normal to the surface).

$$\theta_i \geq \theta_c = \sin^{-1}\left(\frac{1}{n}\right) \qquad (3)$$

The minimum angle of $\theta_i$ is the critical angle $\theta_c$. For example, in a case where the optical element 105 has an refractive index n of 1.49, the critical angle $\theta_c$ is about 42.16 degrees. That is, light having an incident angle smaller than the critical angle $\theta_c$ is emitted from the optical element 105, and light having an incident angle larger than the critical angle $\theta_c$ propagates in the optical element 105 while being totally reflected. Because of this, light reflected by the second surface 204b preferably enters the side surface 202 at an incident angle smaller than the critical angle $8_c$.

In a case where the optical element 105 is made of a material having a refractive index n of 1.414 or higher, the critical angle $\theta_c$ is equal to or smaller than 45 degrees. In this case, when light that has entered from the incidence surface 201 at an incident angle $\theta_{i0}$ impinges on the side surface 202 perpendicular to the incidence surface 201, the incident angle $\theta_{i1}$ of the light on the side surface 202 is always equal to or larger than the critical angle $\theta_c$ according to the expression (4), even if the incident angle $\theta_{i0}$ is 90 degrees. Since PMMA, PC, glass, and the like each have a refractive index n of 1.414 or higher, light that has entered from the incidence surface 201 of the optical element 105 made of one of these materials is totally reflected by the side surface 202, and propagates in the optical element 105.

$$\sin\theta_{i0} = n \times \sin\theta_{r0} \quad , \quad 0 \leq \sin\theta_{i0} < 90$$

$$\theta_{i1} = 90 - \theta_{r0} = 90 - \sin^{-1}\left(\frac{\sin\theta_{i0}}{n}\right) \qquad (4)$$

In a case where light that has entered at the incident angle $\theta_{i1}$ is totally reflected, the exit angle $\theta_{r1}$ is as shown in the expression (5).

$$\theta_{r1} = \theta_{i1} \qquad (5)$$

The light emitted at the exit angle $\theta_{r1}$ is reflected by the second surface (reflective surface) 204b having an angle $\theta$ with respect to the central axis 210, and again enters the side surface 202. The incident angle $\theta_{i2}$ of the light at this stage is as shown in the expression (6).

$$\theta_{i2} = 2\theta - \theta_{r1} \qquad (6)$$

To prevent total reflection of the light that reenters the side surface 202, the incident angle $\theta_{i2}$ should be smaller than the critical angle $\theta_c$. Therefore, the following condition should be satisfied.

$$\theta_{i2} < \theta_c \qquad (7)$$

Thus, the relationships shown below are established according to the expressions (4) through (7).

$$\theta_c > \theta_{i2} = 2\theta - \theta_{r1} = 2\theta - \theta_{i1} = 2\theta - 90 + \sin^{-1}\left(\frac{\sin\theta_{i0}}{n}\right)$$

$$2\theta < 90 + \theta_c - \sin^{-1}\left(\frac{\sin\theta_{i0}}{n}\right) \qquad (8)$$

$$\theta < 45 + \frac{\theta_c - \sin^{-1}\left(\frac{\sin\theta_{i0}}{n}\right)}{2}$$

According to the expression (8), in a case where the incident angle $\theta_{i0}$ is 90 degrees, $\sin\theta_{i0} = 1$, and $\theta < 45$, because the second term on the right side is eliminated from the expression (3).

In view of the above, the angle $\theta$ of the second surface (reflective surface) 204b with respect to the central axis 210 is preferably smaller than 45 degrees. In practice, however, the proportion of light that impinges on the incidence surface 201 of the optical element 105 and has an incident angle $\theta_{i0}$ close to 90 degrees is small in some cases. Therefore, even if the angle $\theta$ is made larger, the influence on efficiency may be small. For this reason, the angle $\theta$ may be smaller than 50 degrees.

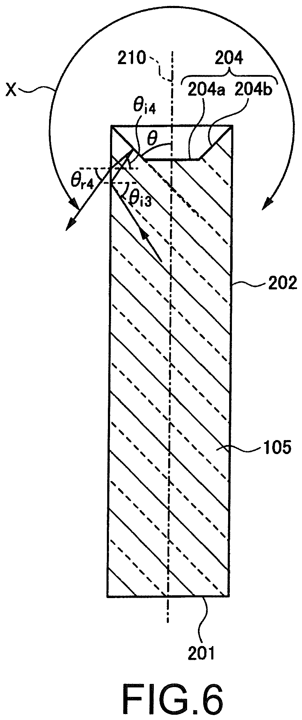

Also, where X represents the 1/2 light distribution angle, and n represents the refractive index of the optical element 105, light is not emitted in directions at angles equal to or larger than the 1/2 light distribution angle, unless the angle $\theta$ of the second surface (reflective surface) 204b with respect to the central axis 210 satisfies the condition shown in the expression (2). This aspect is now described with reference to FIG. 6.

When light that has entered the side surface 202 at an incident angle $\theta_{i3}$ is totally reflected, is reflected by the second surface (reflective surface) 204b having an angle $\theta$ with respect to the central axis 210, and reenters the side surface 202, the incident angle $\theta_{i4}$ of the light at this stage is as shown in the following expression (9) based on the expressions (5) and (6).

$$\theta_{i4} = 2\theta - \theta_{i3} \qquad (9)$$

The exit angle $\theta_{r4}$ of the light emitted in the direction of the 1/2 light distribution angle X is as shown in the following expression (10).

$$\sin\theta_{i4} = n \times \sin\theta_{r4}$$

$$\frac{X}{2} - 90 = \theta_{r4} = \sin^{-1}\left(n \times \sin\theta_{i4}\right) \qquad (10)$$

According to the expressions (9) and (10), the following expression (11) is obtained.

$$\theta = \frac{\theta_{i3} + \sin^{-1}\left\{\frac{1}{n} \times \left[-\cos\left(\frac{X}{2}\right)\right]\right\}}{2} \qquad (11)$$

Since the incident angle $\theta_{i3}$ of the light totally reflected by the side surface 202 is equal to or larger than the critical angle $\theta_c$, the following expression (12) is obtained according to the expression (3).

$$\theta_{i3} \geq \theta_c = \sin^{-1}\left(\frac{1}{n}\right) \qquad (12)$$

The expression (2) is derived from the expressions (11) and (12).

In an example, the material of the optical element 105 is PMMA (refractive index n = 1.49), and the target 1/2 light distribution angle is 280 degrees. In this case, the light propagating in the optical element 105 has an incident angle $\theta_{i3}$ to the side surface 202 equal to or larger than the critical angle (42.16 degrees). Therefore, in order for the light totally reflected by the side surface 202 and reflected by the second surface (reflective surface) 204b to exit in the direction of 140 degrees, which is half the 1/2 light distribution angle, the angle $\theta$ of the second surface (reflective surface) 204b with respect to the central axis 210 should be 36.55 degrees or larger according to the expression (2). In view of this, the angle $\theta$ of the second surface (reflective surface) 204b with respect to the central axis 210 preferably satisfies the condition shown in the expression (2).

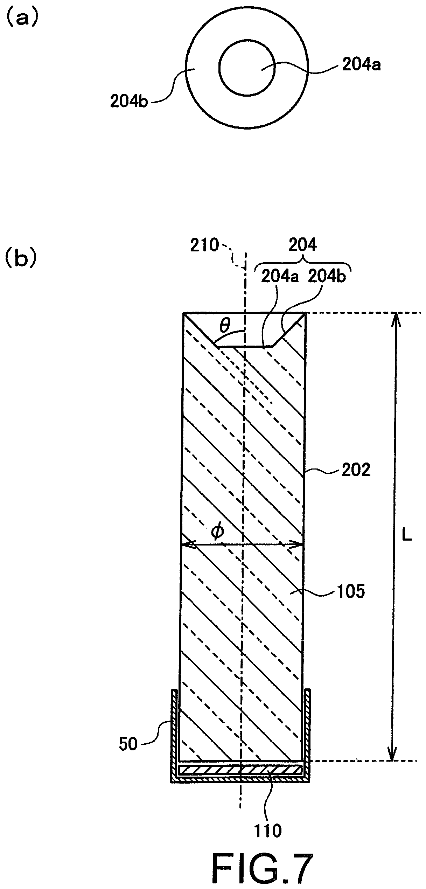

Referring now to FIGS. 7 through 9, setting of a survey of the various parameters for the optical element (light guiding rod) 105 of the first embodiment and the results are described. FIG. 7(a) is a projection view of the optical element 105 used for the parameter survey, viewed from the direction of the central axis 210. FIG. 7(b) is a cross-sectional view showing the shape of the optical element 105 used for the parameter survey. The optical element 105 has a diameter $\varphi$ of 1 mm and a height L of 5 mm (FIG. 7(b)). Where $A_1$ represents a projected area obtained by projecting the recessed surface 204 (the surface formed with the first surface 204a and the second surface 204b) onto a plane perpendicular to the central axis 210, and $A_2$ represents a projected area obtained by projecting the second surface (reflective surface) 204b onto a plane perpendicular to the central axis 210, the projected area ratio a of the second surface (reflective surface) 204b to the recessed surface 204 is expressed as a = $A_2/A_1$. In the optical element 105 used for this parameter survey, a black mask 50 that covers the bottom surface and the side surface of the LED 110 and part of the side surface on the bottom surface side of the optical element 105 was provided to prevent leakage of light. The angle $\theta$ of the second surface (reflective surface) 204b with respect to the central axis 210, and the projected area ratio a are parameters in the parameter survey. Light passes through the first surface (transmissive surface) 204a. A simulation was conducted, and, in the simulation, the distances between the LED 110 and the black mask 50 and the optical element 105 were 0.01 mm, the reflectance of the second surface (reflective surface) 204b was 100%, and the absorption rate of the LED 110 and the black mask 50 was 100%.

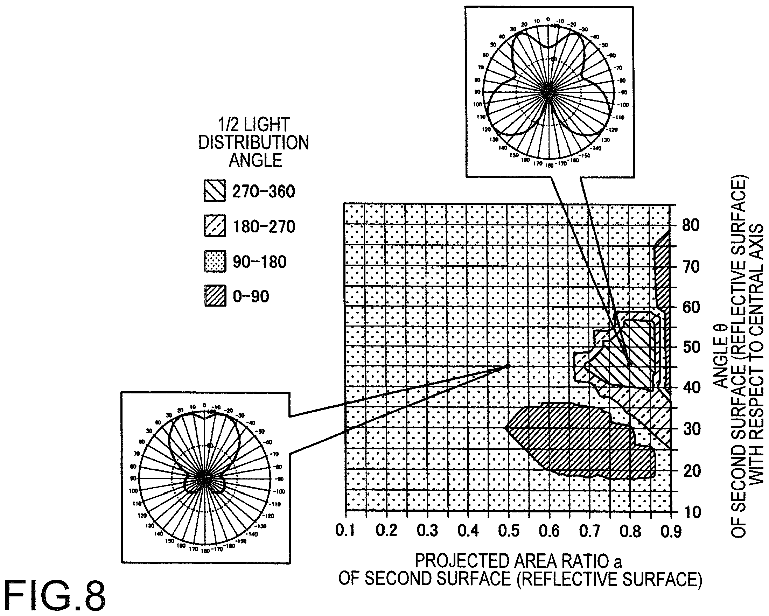

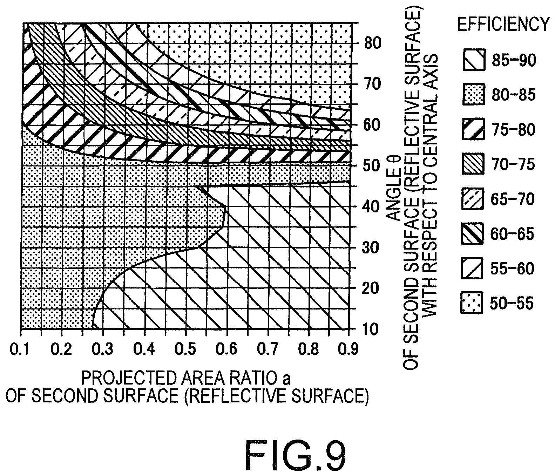

FIG. 8 shows the relationship between the projected area ratio a of the second surface (reflective surface) 204b and the angle $\theta$ of the second surface (reflective surface) 204b with respect to the central axis 210 in a case where the 1/2 light distribution angle was changed. FIG. 9 shows the relationship in a case where light use efficiency was changed.

As can be seen from FIG. 8, in a case where the 1/2 light distribution angle is changed, the intensity of reflected light is insufficient, unless the projected area ratio a of the second surface (reflective surface) 204b is 0.5 or higher. Therefore, the 1/2 light distribution angle cannot be widened. For example, in a case where the projected area ratio a of the second surface (reflective surface) 204b is 0.5, and the angle $\theta$ of the second surface (reflective surface) 204b is 45 degrees, there is a large quantity of transmitted light while there is a small quantity of reflected light. Accordingly, the 1/2 light distribution angle narrows to about 125 degrees. In a case where the projected area ratio a of the second surface (reflective surface) 204b is 0.8, and the angle $\theta$ of the second surface (reflective surface) 204b is 45 degrees, the proportion of the transmitted light and the proportion of the reflected light are substantially equal. Accordingly, the 1/2 light distribution angle widens to about 334 degrees. In view of this, the projected area ratio a should be 0.5 or higher. Here, the projected area ratio a is set are 0.5 or higher, because the 1/2 light distribution angle varies depending on the shapes of the first surface (transmissive surface) 204a and the second surface (reflective surface) 204b.

As can be seen from FIG. 9, in a case where efficiency is changed, the efficiency sharply decreases when the angle $\theta$ of the second surface (reflective surface) 204b is 45 degrees or larger. This is because, when the angle $\theta$ of the second surface (reflective surface) 204b is 45 degrees or larger, the light reflected by the second surface (reflective surface) 204b enters the side surface 202 of the optical element 105, and, as a result, the light that is totally reflected returns to the LED 110 while propagating in the optical element 105, as described above with reference to FIG. 5. Therefore, the efficiency of the optical element 105 becomes lower, unless the angle $\theta$ of the second surface (reflective surface) 204b is smaller than 45 degrees.

It should be noted that the projected area ratio a of the second surface (reflective surface) 204b is preferably 0.7 to 0.85, and the angle θ of the second surface (reflective surface) 204b to the central axis 210 is preferably 40 to 45 degrees. In these regions, the 1/2 light distribution angle is large, and efficiency is high, as can also be seen from the graph showing the parameter survey results.

As described so far, according to the first embodiment, it is possible to provide an optical element and an LED lighting device that are capable of distributing light in all directions without a change in the high luminance of the LED.

(Second Embodiment)

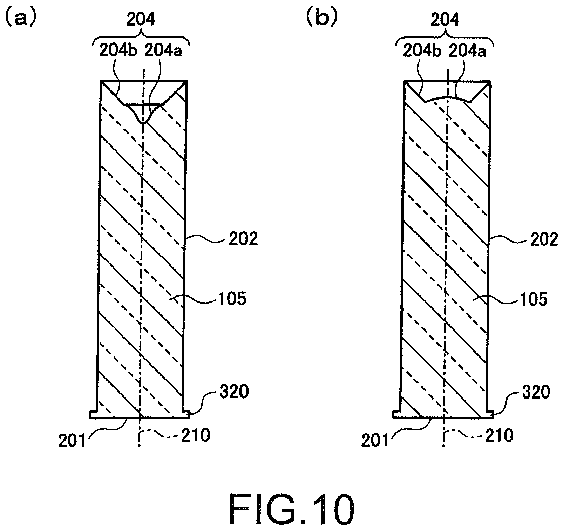

FIG. 10(a) shows a cross-section of an optical element (light guiding rod) 105 according to a second embodiment. The optical element 105 of the second embodiment has the same shape as that of the optical element 105 shown in Fig. 1, except that the first surface (transmissive surface) 204a is recessed toward the incidence surface 201. Alternatively, the first surface (transmissive surface) 204a may protrude toward the exit surface side, or may have a concave shape facing the incidence surface 201, as in a modification of the second embodiment shown in FIG. 10(b). As shown in FIGS. 10(a) and 10(b), the first surface 204a is formed with a curved surface, so that unevenness in the light distribution particularly from the first surface (transmissive surface) 204a can be reduced, and a uniform distribution can be achieved.

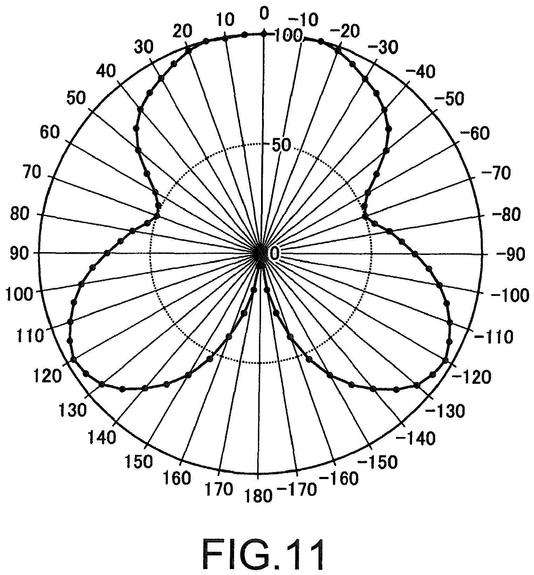

FIG. 11 shows the light distribution of the optical element according to the modification of the second embodiment shown in FIG. 10(b). As can be seen from FIG. 11, unevenness in the direction of the central axis 210 is smaller than that in the light distribution of the first embodiment shown in FIG. 2.

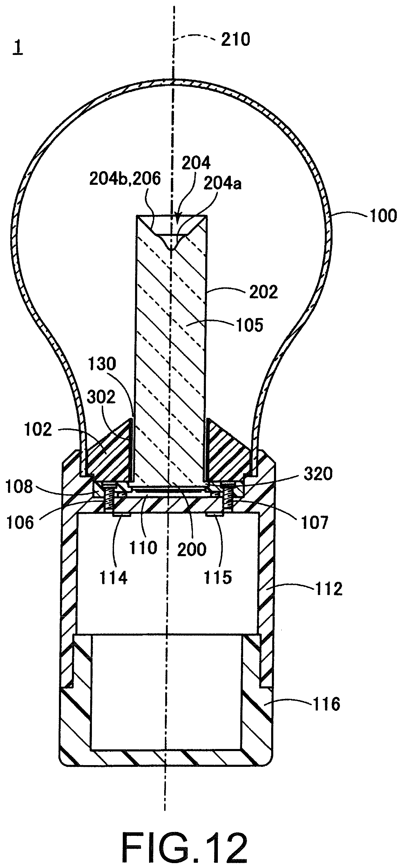

It should be noted that the shape of the curved surface is not necessarily the same as that of this embodiment, and may be any shape such as a U-shape or a substantially curved shape formed with a large number of flat surfaces, as long as the same effects as those of this embodiment can be achieved. FIG. 12 shows the structure of an LED lighting device 1 using the optical element 105 of the second embodiment shown in FIG. 10(a).

Like the first embodiment, the second embodiment can also provide an optical element and an LED lighting device that are capable of distributing light in all directions without a change the high luminance of the LED.

Further, In the LED lighting device 1 of the second embodiment, the housing (socket) 112 has a heat releasing function, and the LED 110, the optical element 105, and the globe 100 are integrally secured to the housing 112 by the spacer 108, the cover 102, the screws 114 and 115, and the like, as in the first embodiment. Thus, an LED lighting device integrally formed with a housing that has a heat releasing function is obtained.

(Third Embodiment)

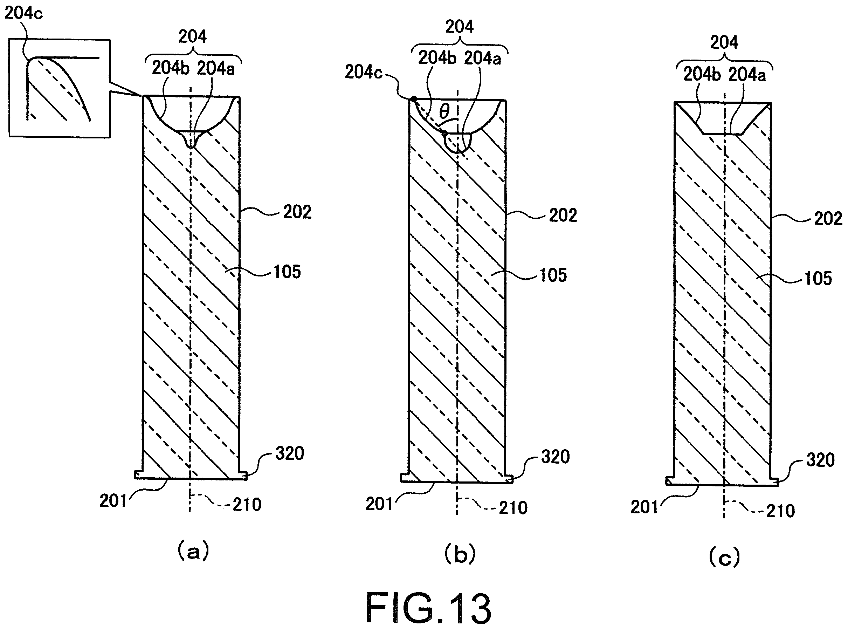

FIG. 13(a) shows the cross-sectional shape of an optical element (light guiding rod) 105 according to a third embodiment.

The optical element 105 of the third embodiment has the same structure as that of the optical element 105 of the second embodiment shown in FIG. 10(a), except that the flat surface of the second surface 204b is replaced with a curved surface, and a third surface 204c to be joined to the side surface 202 is formed on the outer side of the second surface 204b. The third surface 204c is a transmissive surface. Alternatively, the first surface 204a may be a flat surface. In FIG. 13(a), the second surface 204b has a curved surface that protrudes toward the incidence surface 201.

As the second surface 204b is formed with a curved surface in the third embodiment, unevenness in the light distribution from the first surface 204a and the second surface 204b can be reduced, and a uniform distribution can be achieved.

(First Modification)

FIG. 13(b) shows the cross-sectional shape of an optical element 105 according to a first modification of the third embodiment. Unlike the optical element 105 of the third embodiment shown in FIG. 13(a), the optical element 105 of the first modification has a large projected area when the first surface (transmissive surface) 204a is viewed from the direction of the central axis 210, and the shape of the curved surface is a U-shape.

In the third embodiment and its first modification, the angle θ of the second surface 204b is the angle between the central axis 210 and the straight line connecting the start point to form the second surface 204b and the end point of the second surface 204b, as shown in FIG. 13(b).

(Second Modification)

FIG. 13(c) shows the cross-sectional shape of an optical element 105 according to a second modification of the third embodiment. The optical element 105 of the second modification differs from the optical element 105 of the first embodiment shown in FIG. 1, in that the second surface 204b is formed with a curved surface that protrudes toward the exit surface, or is recessed with respect to the incidence surface 201.

(Third Modification)

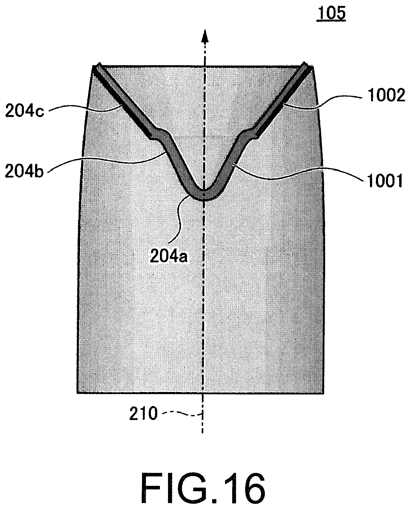

FIG. 16 is a cross-sectional view of an optical element 105 of a third modification, taken along a plane including the central axis 210. In FIG. 16, a transparent coating 1001 and a reflective coating 1002 are applied to a recessed surface formed with a curved surface. The transparent coating 1001 covers the entire recessed surface and the reflective coating 1002, and functions as a protective film. The transparent coating 1001 also has a function of reducing reflection of light beams on the first surface 204a and the second surface 204b. The transparent coating 1001 also has a function of reducing total reflection of a weak light beam propagating in the reflective coating 1002 on the third surface 204c from the interface formed with the reflective coating 1002 and the external environments. The transparent coating 1001 is normally made of a material having a lower refractive index than the optical element 105 of this embodiment. Since the transparent coating 1001 covers the entire recessed surface, there is an advantage that masking does not need to be performed when the recessed surface is created. Furthermore, in the light guiding rod of the third modification, there are no components other than the transparent coating 1001 and the reflective coating 1002 on the outer surface of the recess. Thus, the heat releasing effect can be enhanced.

In the third embodiment and its modifications, the first surface 204a may be either a flat surface or a curved surface. Also, the second surface 204b may have either a shape recessed toward the light source (FIGS. 13(a) and 13(b)) or a shape protruding toward the opposite side from the light source (FIG. 13(c)). Further, the shape of the curved surface is not necessarily the same as that of this embodiment, and may be any shape such as a substantially curved shape formed with a large number of flat surfaces, as long as the same effects as those of this embodiment can be achieved. The third surface 204c may be either a flat surface or a curved surface.

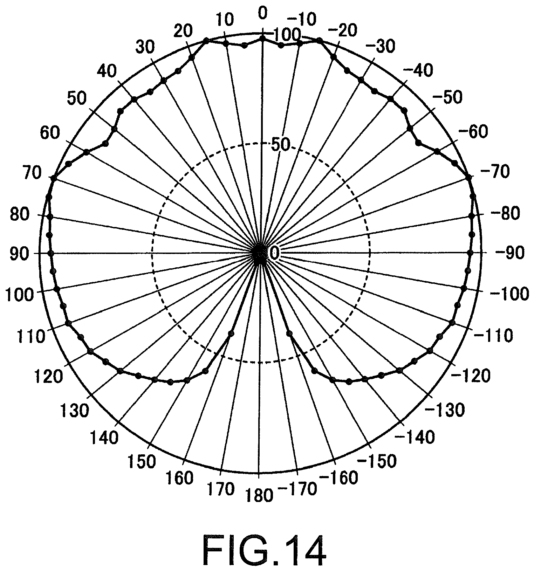

FIG. 14 shows the result of analysis of the light distribution of the LED lighting device 1 using the optical element 105 shown in FIG. 13(a). As can be seen from FIG. 14, it is possible to obtain an LED lighting device in which light evenly spreads in almost all directions with a 1/2 light distribution angle of 310 degrees. However, in a portion of the curved surface forming the second surface (reflective surface) 204b, the angle $\theta$ with respect to the optical axis is larger than 45 degrees. Therefore, efficiency is lower than in the first embodiment and the second embodiment.

Like the first embodiment or the second embodiment, the third embodiment can also provide an optical element and an LED lighting device that are capable of distributing light in all directions without a change the high luminance of the LED.

(Fourth Embodiment)

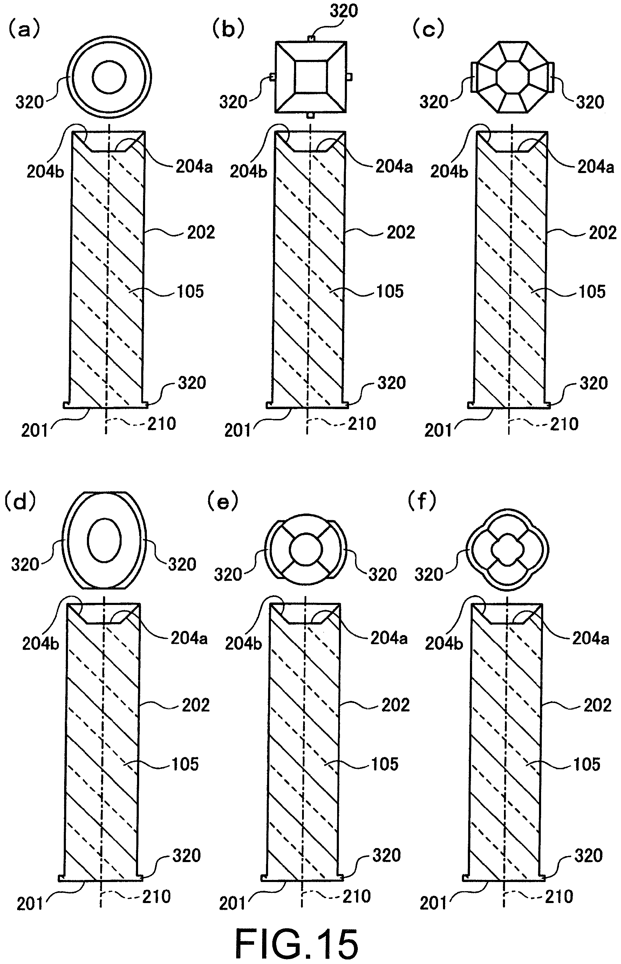

FIG. 15(a) shows a cross-section of an optical element of a fourth embodiment, and a plan view of the optical element as viewed from the central axis. In the optical element 105 of the fourth embodiment, as shown in FIG. 15(a), the cross-section perpendicular to the central axis 210 has a round shape, and a protruding portion 320 is disposed along the entire outer circumference of the optical element 105.

However, the cross-section perpendicular to the central axis 210 may have a rectangular shape, and the protruding portion 320 may be disposed on a portion of each of the four side surfaces, as in an optical element 105 according to a first modification of the fourth embodiment shown in FIG. 15(b).

Also, the cross-section perpendicular to the central axis 210 may have an octagonal shape, and two protruding portions 320 may be disposed on two side surfaces on opposite sides, as in an optical element 105 according to a second modification of the fourth embodiment shown in FIG. 15(c).

Further, the cross-section perpendicular to the central axis 210 may have an elliptical shape, and two protruding portions 320 may be disposed on two side surfaces on opposite sides, as in an optical element 105 according to a third modification of the fourth embodiment shown in FIG. 15(d).

Also, the cross-section perpendicular to the central axis 210 may have the shape of four petals, and two protruding portions 320 may be disposed on two side surfaces on opposite sides, as in an optical element 105 according to a fourth modification of the fourth embodiment shown in FIG. 15(e).

Further, the cross-section perpendicular to the central axis 210 may have the shape of four petals, and a protruding portion 320 may be disposed along the entire outer circumference, as in an optical element 105 according to a fifth modification of the fourth embodiment shown in FIG. 15(f).

As described above, the planar shape as viewed from the central axis 210 or the shape of a cross-section perpendicular to the central axis 210 may be a round shape, an elliptical shape, a polygonal shape such as a rectangular shape or an octagonal shape, or a petal shape, as in the optical elements 105 of the fourth embodiment and its modifications. The fourth embodiment is not limited to these shapes, and any shape may be used, as long as the same effects as those of the first through third embodiments can be achieved.

Like the first through third embodiments, the fourth embodiment can also provide an optical element and an LED lighting device that are capable of distributing light in all directions without a change the high luminance of the LED.
It should be noted that the LED lighting device of any of the above embodiments may be a socket-integrated LED lighting device.
Further, the LED lighting device of any of the above embodiments may be a housing-integrated LED lighting device in which the housing 112 that secures the globe 100 as well as the LED 110 has a heat releasing function.
While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1.  An optical element comprising: an incidence surface facing a light source; a side surface intersecting with the incidence surface; and a recessed surface facing the incidence surface and intersecting with the side surface, the recessed surface having a shape protruding toward the incidence surface,
    wherein the recessed surface includes: a first surface having a shape of a curved surface through which a central axis connecting a central portion of the incidence surface and a central portion of the recessed surface extends; and a second surface joined to the first surface and to the side surface, the first surface transmits light, a light reflecting member is provided on the second surface, and a cross-section of the optical element perpendicular to the central axis has a uniform external shape.

2.  An optical element comprising: an incidence surface facing a light source; a side surface intersecting with the incidence surface; and a recessed surface facing the incidence surface, the recessed surface having a shape protruding toward the incidence surface,
    wherein the recessed surface includes: a first surface having a shape of a curved surface through which a central axis connecting a central portion of the incidence surface and a central portion of the recessed surface extends; a second surface joined to the first surface; and a third surface joined to the second surface and to the side surface, the first surface transmits light, a light reflecting member is provided on the second surface, the third surface transmits light, and a cross-section of the optical element perpendicular to the central axis has a uniform external shape.

3.  The optical element according to claim 1 or 2, wherein, in the recessed surface, a ratio of a second projected area projected on a plane perpendicular to the central axis with respect to the second surface, to a first projected area projected on a plane perpendicular to the central axis with respect to the recessed surface is at least 0.5.

4.  The optical element according to any of claims 1 through 3, wherein an angle $\theta$ at which the second surface intersects with the central axis satisfies the following condition:

$$\theta \geq \frac{\sin^{-1}\left(\frac{1}{n}\right) + \sin^{-1}\left\{\frac{1}{n} \times \left[-\cos\left(\frac{X}{2}\right)\right]\right\}}{2}$$

    where X represents a 1/2 light distribution angle, and n represents a refractive index of the optical element.

5.  The optical element according to any of claims 1 through 4, wherein an angle $\theta$ at which the second surface intersects with the central axis is smaller than 50 degrees.

6.  The optical element according to any of claims 1 through 5, wherein the second surface is a flat surface.

7.  The optical element according to any of claims 1 through 5, wherein the first surface is a curved surface protruding toward the incidence surface, and the second surface is a flat surface.

8.  The optical element according to any of claims 1 through 5, wherein the first surface is a curved surface recessed with respect to the incidence surface, and the second surface is a flat surface.

9. The optical element according to any of claims 1 through 5, wherein the first and second surfaces are curved surfaces protruding toward the incidence surface.

10. The optical element according to any of claims 1 through 5, wherein the first and second surfaces are curved surfaces recessed with respect to the incidence surface.

11. The optical element according to any of claims 1 through 5, wherein the first surface is a flat surface, and the second surface is a curved surface protruding toward the incidence surface.

12. The optical element according to any of claims 1 through 5, wherein the first surface is a curved surface protruding toward the incidence surface, and the second surface is a curved surface recessed with respect to the incidence surface.

13. The optical element according to any of claims 1 through 5, wherein the first surface is a curved surface protruding toward the incidence surface, and the second surface is a curved surface protruding toward the incidence surface.

14. The optical element according to any of claims 1 through 13, wherein the cross-section of the optical element perpendicular to the central axis has one of a round shape, a polygonal shape, an elliptical shape, and a petal shape.

15. The optical element according to any of claims 1 through 14, wherein a protruding portion is provided on a portion of the side surface, the portion being located near the incidence surface.

16. The optical element according to claim 2, further comprising: a reflecting member disposed on the first surface; and a transparent member disposed on the first through third surfaces, the transparent member covering the reflecting member.

17. An LED lighting device comprising:

    a light source including an LED;
    the optical element according to any of claims 1 through 16; and
    a globe that covers the optical element.

18. The LED lighting device according to claim 17, further comprising a housing that secures the light source and secures the globe.

19. The LED lighting device according to claim 18, wherein the housing has a heat releasing function, and the light source, the optical element, and the globe are integrated with the housing.

FIG.1

FIG.2

# FIG.3

FIG.4

**FIG.5**

FIG.6

(a)

(b)

# FIG.7

FIG.8

FIG.9

(a)

204
204b 204a

202

105

320

201      210

(b)

204
204b 204a

202

105

320

201      210

# FIG.10

FIG.11

FIG.12

FIG.13

EP 3 392 550 A1

FIG.14

FIG.15

FIG.16

## INTERNATIONAL SEARCH REPORT

International application No.

PCT/JP2016/076995

A.    CLASSIFICATION OF SUBJECT MATTER

*F21S2/00*(2016.01)i, *F21V8/00*(2006.01)i, *G02B5/10*(2006.01)i, *G02B6/00* (2006.01)i, *G02B17/08*(2006.01)i, *H01L33/00*(2010.01)i, *H01L33/58*(2010.01)i, *H01L33/60*(2010.01)i, *F21Y115/10*(2016.01)n

According to International Patent Classification (IPC) or to both national classification and IPC

B.    FIELDS SEARCHED

Minimum documentation searched (classification system followed by classification symbols)

F21S2/00, F21V8/00, G02B5/10, G02B6/00, G02B17/08, H01L33/00, H01L33/58, H01L33/60, F21Y115/10

Documentation searched other than minimum documentation to the extent that such documents are included in the fields searched

Jitsuyo Shinan Koho          1922–1996    Jitsuyo Shinan Toroku Koho    1996–2016
Kokai Jitsuyo Shinan Koho    1971–2016    Toroku Jitsuyo Shinan Koho    1994–2016

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2012-514842 A    (Koninklijke Philips Electronics N.V.), 28 June 2012 (28.06.2012), paragraphs [0027] to [0034], [0041] to [0047]; fig. 1a to 5 & US 2011/0267835 A1 paragraphs [0035] to [0041], [0048] to [0054]; fig. 1a to 5 & WO 2010/079391 A1      & KR 10-2011-0106921 A & CN 102272514 A | 1-14<br>15,17-19<br>16 |
| Y<br>A | JP 2015-11897 A  (Toshiba Corp.), 19 January 2015 (19.01.2015), paragraphs [0011] to [0012], [0019]; fig. 1 (Family: none) | 15,17-19<br>16 |

☐    Further documents are listed in the continuation of Box C.          ☐    See patent family annex.

| | |
|---|---|
| *        Special categories of cited documents:<br>"A"    document defining the general state of the art which is not considered    to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| 25 November 2016 (25.11.16) | 06 December 2016 (06.12.16) |

| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**REFERENCES CITED IN THE DESCRIPTION**

**Patent documents cited in the description**

- JP 2014063614 A